# FASCICULE DE BREVET EUROPEEN

(11) **EP 2 088 618 B1**
(45) Date de publication et mention de la délivrance du brevet: **19.10.2011**
(21) Numéro de dépôt: 09354004.5
(22) Date de dépôt: 27.01.2009
(51) Int. Cl.: H01L 21/28, H01L 29/423, H01L 29/788, H01L 29/792

(54) **Procédé de réalisation d'une grille flottante**
Realisierungsverfahren eines Freischwebegatters
Method of producing a floating gate

(30) Priorité: 08.02.2008 FR 0800665
(43) Date de publication de la demande: 12.08.2009
(73) Titulaire: Commissariat à l'Énergie Atomique et aux Énergies Alternatives, 75015 Paris (FR); Centre National de la Recherche Scientifique, 75794 Paris Cedex 16 (FR); Université Joseph Fourier, 38041 Grenoble Cedex 9 (FR)
(72) Inventeur: Molas, Gabriel, 38000 Grenoble (FR); Aissou, Karim, 38700 Corenc (FR); Baron, Thierry, 38120 Saint-Egrève (FR)
(74) Mandataire: Hecké, Gérard

(56) Documents cités:
- US-A1- 2003 193 064
- US-A1- 2004 256 662
- US-A1- 2005 287 717
- BARON T ET AL: "NUCLEATION CONTROL OF CVD GROWTH SILICON NANOCRYSTALS FOR QUANTUM DEVICES" MICROELECTRONIC ENGINEERING, ELSEVIER PUBLISHERS BV., AMSTERDAM, NL, vol. 61/62, 1 juillet 2002 (2002-07-01), pages 511-515, XP008035315 ISSN: 0167-9317

## Description

### Domaine technique de l'invention

L'invention est relative à un procédé de réalisation d'une grille flottante sur un substrat, la grille flottante comportant, sur un premier isolant de grille, un second isolant de grille comportant, dans un plan parallèle au substrat, une alternance de premières et secondes lignes parallèles, respectivement en premier et second matériaux distincts.

### État de la technique

La mémoire flash est devenue un produit électronique incontournable. Sa vitesse de fonctionnement élevée, sa grande durée de vie et sa faible consommation en ont fait un élément indispensable dans bon nombre de produits à vocation mobile.

La mémoire flash est classiquement constituée d'un transistor de type MOS ayant une grille flottante comme cellule mémoire de base. La définition d'un état haut et d'un état bas est réalisée en injectant ou en éliminant des porteurs de charge (généralement des électrons) dans la grille flottante du transistor. La présence ou l'absence d'électrons dans la grille flottante modifie les caractéristiques électriques du transistor qui sont alors utilisées pour contrôler si la cellule mémoire est dans un état haut ou dans un état bas.

L'augmentation des capacités de stockage avec des mémoires flash multibits fait l'objet de nombreuses études. Le remplacement des mémoires classiques à 2 bits (0 et 1) par des mémoires flash multibits permet de définir, en plus des états bas et haut, une multitude de niveaux intermédiaires.

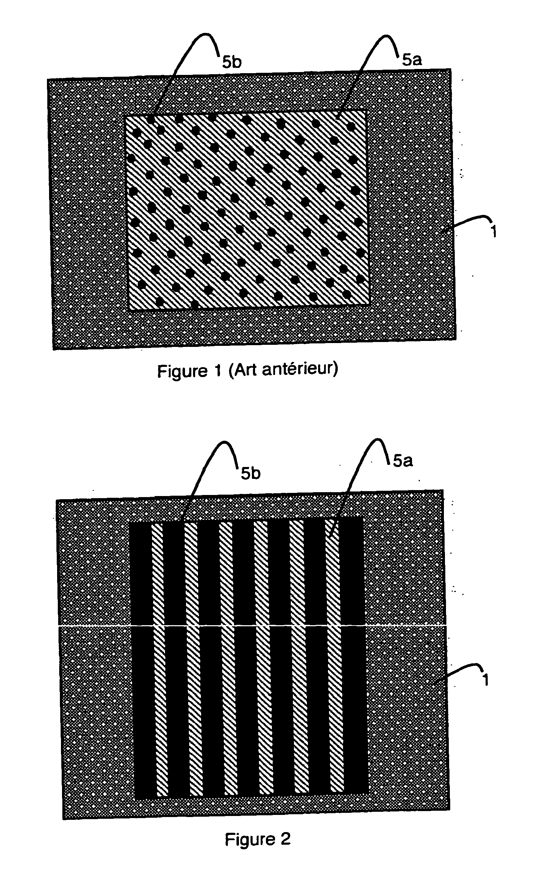

Le brevet US 7045851 décrit l'utilisation d'un copolymère dibloc, constitué de polystyrène et de polyméthacrylate de méthyle (PMMA), déposé sur une couche d'oxyde de silicium pour former une grille flottante discrète d'un transistor à effet de champ. Les chaînes de polyméthacrylate de méthyle forment dans le copolymère dibloc un réseau de nodules 5b sensiblement cylindriques et verticaux dans une matrice de polystyrène 5a (figure 1). Le réseau de nodules de polyméthacrylate de méthyle est éliminé pour former un masque de gravure, qui est reproduit sur la couche d'oxyde de silicium. Un réseau de nodules de silicium amorphe, similaire au réseau de polyméthacrylate de méthyle est formé à travers ce masque dans le diélectrique de grille de la grille flottante. L'inconvénient majeur de ce genre de dispositif est que les zones piégeant les électrons, liées à un bit, ne sont pas délimitées physiquement ce qui conduit à un mauvais contrôle de la tension de seuil de chaque bit. De plus, la présence de nodules entre deux zones piégeant les électrons peut entraîner une diffusion de charge entre ces zones. Cette diffusion de charge accentue le mauvais contrôle de la tension de charge.

Le document US-A-2003/0193064 décrit une mémoire flash ayant une grille flottante constituée par deux grilles flottantes élémentaires disposées côte à côte. Chaque grille flottante élémentaire a des dimensions bien contrôlées grâce à sa réalisation au moyen d'espaceurs latéraux et d'étapes de dépôt et de gravure successives. La taille de cette grille est limitée par le procédé de photolithographie. Cette mémoire flash a des niveaux bien dissociés mais son procédé de fabrication est complexe, coûteux et ne permet pas la réalisation de plus de deux grilles élémentaires.

### Objet de l'invention

L'invention a pour objet un procédé de réalisation d'une grille flottante qui soit facile à mettre en oeuvre.

Selon l'invention, ce but est atteint par les revendications annexées et plus particulièrement par le fait que le procédé comporte sur le premier isolant de grille :
- le dépôt d'une couche en copolymère dibloc, comportant dans un plan parallèle au substrat une alternance d'au moins deux polymères,
- l'élimination de l'un des polymères de la couche en copolymère dibloc pour former des saignées parallèles dans la couche en copolymère,
- le remplissage des saignées par le premier matériau pour former les premières lignes,
- l'élimination du reste de la couche de copolymère,
- le dépôt du second matériau, encapsulant les premières lignes.

### Description sommaire des dessins

D'autres avantages et caractéristiques ressortiront plus clairement de la description qui va suivre d'un mode particulier de réalisation de l'invention donné à titre d'exemple non limitatif et représenté aux dessins annexés, dans lesquels
- la figure 1 représente, de manière schématique, en vue de dessus, un copolymère dibloc déposé sur une zone active délimitée par un motif d'isolation et utilisé pour fabriquer une grille flottante selon l'art antérieur,
- la figure 2 représente, de manière schématique, en vue de dessus, l'étape d'un procédé selon l'invention, correspondant à la figure 3,
- les figures 3 à 5 représentent, de manière schématique, en coupe, les étapes successives d'un procédé selon l'invention.

### Description d'un mode de réalisation préférentiel de l'invention

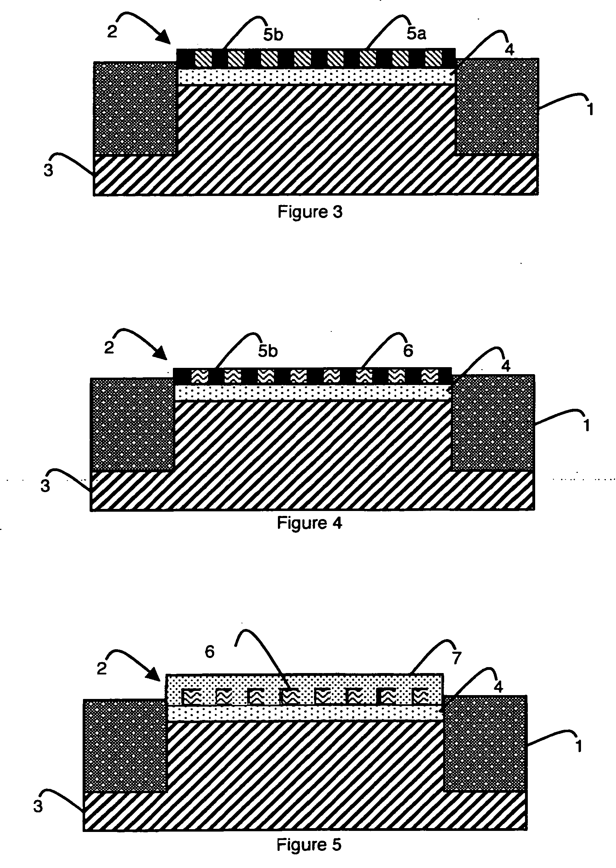

Comme illustré sur les figures 2 et 3, un motif d'isolation 1 délimite une zone active 2 à la surface d'un substrat 3. Le motif d'isolation 1 dépasse vers le haut la surface du substrat 3 et la zone active 2 qu'il délimite. Le motif d'isolation 1 est, par exemple, constitué par une tranchée d'isolation latérale, typiquement en oxyde de silicium, qui dépasse la surface du substrat 3 d'une hauteur comprise, généralement, entre 100 et 500Å. De manière classique, le substrat 3 est un substrat massif en silicium ou un substrat sur isolant.

Sur les figures 3 à 5, le substrat 3 comporte un premier isolant de grille 4 en matériau diélectrique, situé dans la zone active 2. Le premier isolant de grille 4, par exemple en oxyde de silicium, peut être réalisé par oxydation thermique de la zone active 2. Le premier isolant de grille 4 peut également être en nitrure de silicium Si₃N₄ ou en matériau diélectrique à forte constante diélectrique utilisé classiquement pour les isolants de grille en microélectronique, par exemple HfO₂, Al₂O₃, HfAlO, ZrO₂. L'isolant 4 peut aussi être en TiO, SiON ou HfSiO. Sur ce premier isolant de grille 4, est déposée une couche en copolymère dibloc 5, constituée d'au moins deux polymères 5a et 5b non thermodynamiquement miscibles.

L'épaisseur et la composition des polymères formant le copolymère dibloc 5 sont choisies de façon à ce que le copolymère dibloc forme dans un plan parallèle au substrat 3 une alternance des deux polymères 5a et 5b. Cette alternance de polymères représente sensiblement une structure lamellaire perpendiculairement au substrat 3 (figures 2 et 3). Une telle structure peut être obtenue par un copolymère qui présente une structure dite « lamellaire » ou dans une structure dite de « cylindres couchés » perpendiculairement au substrat 3. De telles structures ont notamment été décrites dans l'article de Park et al « Directed Assembly of Lamallae-Forming Block Copolymers by Using Chemically and Topographically Patterned Substrates » Advanced Materials, 2007, 19, 607-611.

Un copolymère 5 avec une structure lamellaire perpendiculaire est classiquement obtenu lorsque la composition des chaînes diblocs est adaptée, avantageusement si la composition volumique en l'un des polymères est comprise entre 0,35 et 0,65.

Le copolymére dibloc 5 est, par exemple, un mélange de polystyrène 5b et de polyméthacrylate de méthyle 5a. Une organisation lamellaire perpendiculaire ou une structure cylindrique couchée au moyen de ce type de mélange sont notamment décrites dans l'article de Park et al. précité.

Pour obtenir une structure perpendiculaire, c'est-à-dire une orientation des chaînes qui soit parallèle au substrat, il est nécessaire que les interactions entre la surface du substrat et les différents blocs de polymères 5a et 5b soient égales. Si la surface du substrat, ici le premier isolant de grile 4, n'est pas adaptée, l'obtention d'une structure perpendiculaire est alors obtenue en neutralisant la surface de départ. La neutralisation d'une surface est classiquement obtenue au moyen d'un film de neutralisation (non représenté) qui peut être un film en matériau polymère qui comporte des chaînes des polymères de la couche 5, mais disposés aléatoirement. Un exemple de réalisation est décrit par Mansky et al. « Controlling Polymer-Surface Interactions with Random Copolymer Brushes » Science 275, 1458, 1997. Lorsque le premier isolant de grille 4 est en oxyde de silicium, un film de neutralisation en matériau polymère comprenant des chaînes de copolymère en polyméthacrylate de méthyle et de polystyrène est déposé préalablement au film de copolymère dibloc 5, entre ce dernier et le premier isolant de grille 4.

Dans le cas d'un copolymère dibloc 5 constitué par des premier et second polymères 5a et 5b, par exemple, du polyméthacrylate de méthyle et du polystyrène, le film de copolymère 5 présente, dans la zone active 2, une alternance de chacun des constituants 5a et 5b (figures 2 et 3) perpendiculairement au substrat 3. En d'autres termes, les chaînes de polymères forment des motifs ou lignes parallèles, ayant chacun au moins une face en contact avec le premier isolant de grille 4 et une face opposée libre. Les autres faces de chaque ligne sont, en règle générale, en contact soit avec le motif d'isolation 1 soit avec l'autre constituant du copolymère 5. A l'intérieur de la zone active 2, le film de copolymère dibloc présente au moins deux lignes d'un de ses constituants séparés par l'autre constituant du film copolymère 5. L'alternance des premier et second polymères 5a et 5b se termine, de préférence, à ses deux extrémités avec le même polymère (5b sur la figure 3).

Le pas du réseau de la couche 5 est contrôlé par la longueur des chaînes de polymère, tout en conservant le critère relatif à la composition en chacun des polymère. Le pas du réseau est choisi en fonction de la taille de la zone active 2 pour éviter de contraindre le film.

Par ailleurs, la longueur des chaînes des polymères est choisie de manière à ce que les lignes s'étendent suivant la largeur du dispositif, c'est-à-dire perpendiculairement à l'axe reliant la source au drain. En d'autres termes, les lignes sont parallèles à l'axe longitudinal de la future grille flottante. Afin de minimiser sa tension de surface, le polymère qui développe des interactions de moindre énergie avec les motifs d'isolation va s'adsorber sur ces derniers. Cette organisation des chaînes de polymère fonctionne pour tout copolymère dibloc dont les deux polymères présentent une affinité différente vis-à-vis du matériau d'isolation. C'est en particulier le cas pour le couple polystyrène 5b / polyméthacrylate de méthyle dans une zone active délimitée par un motif d'isolation 1 en oxyde de silicium. Dans cette configuration, les lignes définies par l'alternance des polymères 5a et 5b ne sont pas orientées selon l'axe drain-source du futur transistor à grille flottante. La zone active 2 est de forme rectangulaire avec sa plus grande dimension orientée suivant l'axe longitudinal de la future grille, ainsi, les chaînes de copolymères s'orientent suivant cette dimension. De ce fait, la plus petite dimension de la zone active est orientée selon l'axe source-drain du futur dispositif. A titre d'exemple, les dimensions de la zone active sont 0,25 x 0,32µm².

De manière conventionnelle, la couche en copolymère dibloc 5 est structurée après son dépôt pour la localiser uniquement au-dessus du premier isolant de grille 4. La structuration du copolymère dibloc 5 peut être réalisée, par exemple, par photolithographie et gravure ou par polissage mécano-chimique.

Comme illustré à la figure 4, un des polymères 5a du copolymère dibloc est ensuite éliminé pour former des saignées parallèles dans la couche en copolymère 5. L'élimination est réalisé par toute technique adaptée. Par exemple, une insolation sous rayonnement ultraviolet profond permet d'éliminer sélectivement le polyméthacrylate de méthyle. La couche 5 comporte alors des lignes constituées par le second polymère 5b, séparées par des saignées correspondant aux lignes constituées initialement par le premier polymère 5a qui a été éliminé. Le premier isolant de grille 4 est alors libre à l'emplacement des saignées. Si un film de neutralisation est utilisé, il est également structuré pour former les saignées et laisser libre le premier isolant de grille 4 au niveau de ces saignées.

Un premier matériau 6, de préférence un matériau métallique ou semi-conducteur, est ensuite déposé, puis structuré, de manière à remplir au moins partiellement les saignées et former ainsi des premières lignes à l'emplacement des lignes en premier polymère 5a éliminé. Le premier matériau 6 est, par exemple, du silicium amorphe ou polycristallin ou une molécule de porphyrine ayant un atome métallique (Zn, Co, Fe) en son centre ou un métal choisi parmi Fe, Co, Pt. Le premier matériau 6 peut être également un matériau diélectrique, par exemple du nitrure de silicium ou un matériau diélectrique à haute permittivité.

Comme illustré à la figure 5, le reste du copolymère dibloc 5, c'est-à-dire le second polymère 5b formant les secondes lignes et éventuellement le reste du film de neutralisation, est ensuite éliminé, par exemple par gravure en utilisant par exemple un plasma O₂. Un second matériau 7 est alors déposé sur le premier isolant de grille 4 et sur les premières lignes en premier matériau 6. Le second matériau 7 est un matériau diélectrique avantageusement choisi parmi les mêmes matériaux que le premier isolant de grille 4.

Le choix des premier et second matériaux 6 et 7 est fait de manière à ce que le premier matériau 6 (métallique, semi-conducteur ou diélectrique) soit capable de retenir en son sein des porteurs de charge (des électrons ou des trous) et d'éviter qu'ils ne diffusent plus tard vers le second matériau 7 ou vers le premier isolant de grille 4. Si le premier matériau 6 qui est apte à piéger des charges est un matériau diélectrique, il présente alors une densité de pièges qui est nettement supérieure à celle du second matériau 7 et du premier isolant de grille 4. La densité de pièges présents dans un matériau diélectrique est, de manière classique, dépendante des conditions de dépôt de ce matériau. Ainsi, il est possible d'avoir des premier et second matériaux 6 et 7 distincts qui présentent des compositions chimiques très proches mais des propriétés électriques distinctes.

En plus des document précités, US-A-2003/0193064 et US 7045851, différents couples de premier et second matériaux 6 et 7 sont décrits par Tan et al « Hafnium Aluminium Oxide as Charge Storage and Blocking-Oxide Layers in SONOS-Type Nonvolatile Memory for High-Speed Operation » IEEE Transaction on Electron Devices, Vol.53, N°4, April 2006, par Chin et al. « Low Voltage High Speed SiO2/AlGaN/AlLaO3/TaN Memory with Good Rétention » Electron Devices Meeting, 2005. IEDM Technical Digest. IEEE International Volume , Issue , 5-7 Dec. 2005 Page(s): 158 -161 et par Wang et al « Long Rétention and Low Voltage Opération Using IrO2/HfAlO/HfSiO/HfAlO Gate Stack for Memory Application » Electron Devices Meeting, 2005. IEDM Technical Digest. IEEE International Volume , Issue , 5-7 Dec. 2005 Page(s): 162 - 165.

Le dépôt du second matériau 7 encapsule les lignes en premier matériau 6 et forme ainsi un second isolant de grille comportant, dans un plan parallèle, au substrat 3, une alternance de premières et secondes lignes parallèles, respectivement en premier matériau 6 et en second matériau 7 distincts. Les premières et secondes lignes sont respectivement situées en lieu et place des premier et second polymères 5a et 5b du copolymère dibloc 5.

En variante (non représentée), le second matériau 7 peut être structuré pour ne former que les secondes lignes en matériau diélectrique séparant les premières lignes en premier matériau 6. Un matériau diélectrique additionnel est alors déposé sur les premières et secondes lignes pour finaliser le second isolant de grille.

Le reste du dispositif, notamment la formation de la grille de contrôle, est ensuite réalisé de manière classique, notamment avec le dépôt d'une électrode de grille, par exemple en polysilicium, et avec la structuration de la grille.

Le dispositif ainsi obtenu est particulièrement avantageux car il permet de réaliser une mémoire multibits ayant plusieurs bits bien définis car chaque ligne en premier matériau correspond à une gille discrète, c'est-à-dire à un bit de la mémoire.

## Revendications

1. Procédé de réalisation d'une grille flottante sur un substrat (3), la grille flottante comportant, sur un premier isolant de grille (4), un second isolant de grille comportant, dans un plan parallèle au substrat (3), une alternance de premières et secondes lignes parallèles, respectivement en premier et second matériaux (6, 7) distincts, procédé **caractérisé en ce qu'**il comporte sur le premier isolant de grille (4) :
- le dépôt d'une couche en copolymère dibloc (5), comportant dans un plan parallèle au substrat (3) une alternance d'au moins deux polymères (5a, 5b),
- l'élimination de l'un des polymères de la couche en copolymère dibloc (5) pour former des saignées parallèles dans la couche en copolymère,
- le remplissage des saignées par le premier matériau (6) pour former les premières lignes,
- l'élimination du reste de la couche de copolymère (5),
- le dépôt du second matériau (7), encapsulant les premières lignes.

2. Procédé selon la revendication 1, **caractérisé en ce que** le premier matériau (6) est un matériau métallique.

3. Procédé selon la revendication 1, **caractérisé en ce que** le premier matériau (6) est un matériau semi-conducteur.

4. Procédé selon l'une quelconque des revendications 1 à 3, **caractérisé en ce que** le second (7) matériau est un matériau diélectrique

5. Procédé selon l'une quelconque des revendications 1 à 4, **caractérisé en ce que** la formation des saignées est réalisée par une insolation sous rayonnement ultraviolet profond.

6. Procédé selon l'une quelconque des revendications 1 à 5, **caractérisé en ce qu'**il comporte le dépôt d'un film de neutralisation entre le premier isolant de grille (4) et le dépôt de la couche en copolymère dibloc (5).

## Claims

1. A method for producing a floating gate on a substrate (3), the floating gate comprising, on a first gate insulator (4), a second gate insulator comprising, in a plane parallel to the substrate (3), an alternation of parallel first and second lines respectively made from distinct first and second materials (6, 7), method **characterized in that** it comprises on the first gate insulator (4):
- deposition of a diblock copolymer layer (5) comprising an alternation of at least two polymers (5a, 5b) in a plane parallel to the substrate (3),
- elimination of one of the polymers of the diblock copolymer layer (5) to form parallel grooves in the copolymer layer,
- filling of the grooves by the first material (6) to form the first lines,
- elimination of the rest of the copolymer layer (5),
- deposition of the second material (7), encapsulating the first lines.

2. The method according to claim 1, **characterized in that** the first material (6) is a metallic material.

3. The method according to claim 1, **characterized in that** the first material (6) is a semi-conductor material.

4. The method according to any one of claims 1 to 3, **characterized in that** the second material (7) is a dielectric material.

5. The method according to any one of claims 1 to 4, **characterized in that** formation of the grooves is achieved by exposure under deep ultraviolet radiation.

6. The method according to any one of claims 1 to 5, **characterized in that** it comprises deposition of a neutralization film between the first gate insulator (4) and deposition of the diblock copolymer layer (5).

## Patentansprüche

1. Verfahren zur Herstellung eines Floating Gates auf einem Substrat (3), wobei das Floating Gate auf einem ersten Gate-Isolator (4) einen zweiten Gate-Isolator aufweist, der in einer Ebene parallel zu dem Substrat (3) einen Wechsel von parallelen ersten und zweiten Leitungen jeweils aus einem ersten und einem zweiten verschiedenen Material (6, 7) aufweist, wobei das Verfahren **dadurch gekennzeichnet ist, dass** es auf dem ersten Gate-Isolator (4) aufweist:
- Aufbringen einer Schicht (5) aus Diblockcopolymer, die in einer Ebene parallel zu dem Substrat (3) einen Wechsel von wenigstens zwei Polymeren (5a, 5b) aufweist,
- Beseitigung eines der Polymere der Schicht (5) aus Diblockcopolymer, um parallele Gräben in der Schicht aus Copolymer zu bilden,
- Füllen der Gräben mit dem ersten Material (6), um die ersten Leitungen zu bilden,
- Beseitigung des Rests der Copolymer-Schicht (5),
- Aufbringen des zweiten Materials (7), das die ersten Leitungen einkapselt.

2. Verfahren nach Anspruch 1, **dadurch gekennzeichnet, dass** das erste Material (6) ein metallisches Material ist.

3. Verfahren nach Anspruch 1, **dadurch gekennzeichnet, dass** das erste Material (6) ein Halbleitermaterial ist.

4. Verfahren nach einem der Ansprüche 1 - 3, **dadurch gekennzeichnet, dass** das zweite Material (7) ein dieelektrisches Material ist.

5. Verfahren nach einem der Ansprüche 1 bis 4, **dadurch gekennzeichnet, dass** die Ausbildung der Gräben durch eine Belichtung unter tiefer UV-Strahlung realisiert wird.

6. Verfahren nach einem der Ansprüche 1 bis 5, **dadurch gekennzeichnet, dass** es das Aufbringen eines Neutralisierungsfilms zwischen dem ersten Gate-Isolator (4) und dem Aufbringen der Schicht (5) aus Diblockcopolymer umfasst.
